## Europäisches Patentamt

## European Patent Office

## Office européen des brevets

(19)

(11) Veröffentlichungsnummer: **0 185 854**
A2

(12) # EUROPÄISCHE PATENTANMELDUNG

(21) Anmeldenummer: **85111869.5**

(22) Anmeldetag: **19.09.85**

(51) Int. Cl.⁴: **H 01 S 3/19**
**H 01 L 33/00**

(30) Priorität: **26.09.84 DE 3435307**

(43) Veröffentlichungstag der Anmeldung:
**02.07.86 Patentblatt 86/27**

(84) Benannte Vertragsstaaten:
**DE FR GB**

(71) Anmelder: **Siemens Aktiengesellschaft**
**Berlin und München Wittelsbacherplatz 2**
**D-8000 München 2(DE)**

(72) Erfinder: **Heinen, Jochen Dr.**
**Dianastrasse 38**
**D-8013 Haar(DE)**

(54) **Halbleiter-Laserdiode mit vergrabener Heterostruktur.**

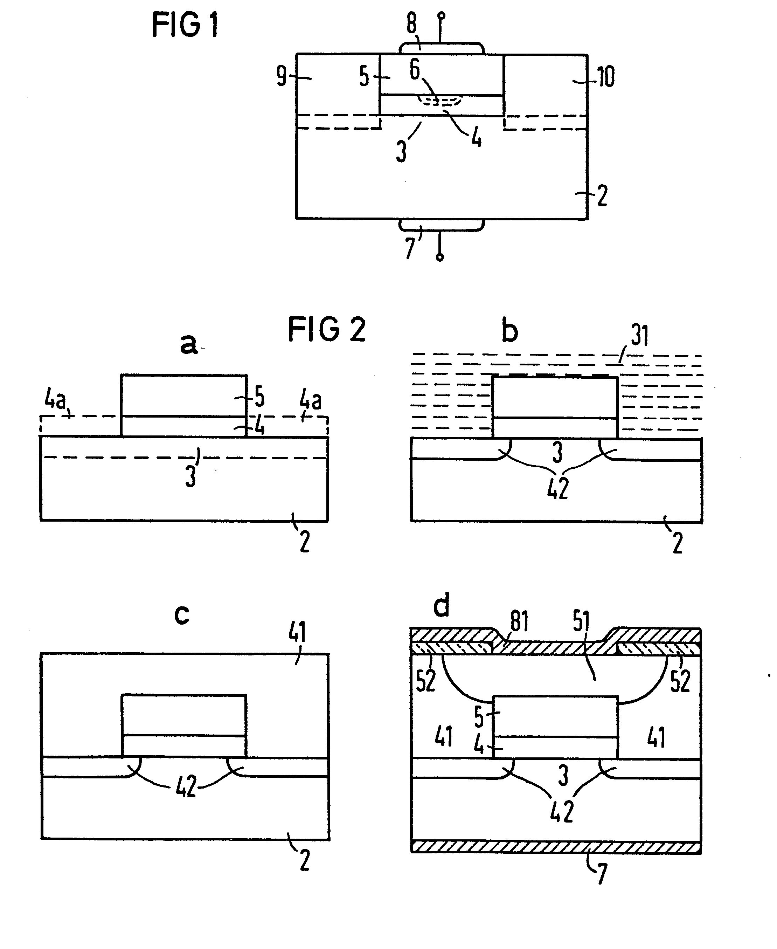

(57) Herstellung einer Doppelhetero-Laserdiode (Fig. 2d) mit streifenförmiger Laserstruktur (4, 5), deren erste Schicht (3) der der Heterostruktur seitlich derselben diffusionsdotiert (42) ist.

Fig 2.

EP 0 185 854 A2

SIEMENS AKTIENGESELLSCHAFT    Unser Zeichen   **0185854**
Berlin und München    VPA 84 P 1779 E

## Halbleiter-Laserdiode mit vergrabener Heterostruktur.

Die vorliegende Erfindung bezieht sich auf ein Verfahren zur Herstellung einer Halbleiter-Laserdiode mit vergrabener Heterostruktur und auf eine solche Laserdiode, wie im Oberbegriff des Patentanspruchs 1 angegeben ist.

Halbleiter-Laserdioden mit vergrabener Heterostruktur sind als BH-Laser (buried hetero-laser) bekannt und die Fig.1 zeigt eine derartige Struktur. Es ist ein Substratkörper 2 und eine Halbleiter-Schichtfolge 3, 4, 5 vorhanden, wobei die Schicht 3 Anteil des Substratkörpers 2 sein kann. Diese Schichtfolge 3, 4, 5 ist eine Folge B/A/B, die die Doppelheteroschichtstruktur bildet. In dieser Schichtfolge liegt die die Laserstrahlung erzeugende streifenförmige Laserzone. Mit 7 und 8 sind Kontaktelektroden zur Zuführung des die Laserdiode speisenden elektrischen Stromes bezeichnet.

Damit der durch die Laserdiode fließende Strom tatsächlich auf den Streifen der Doppelheteroschichtstruktur 3, 4, 5 eingegrenzt bleibt, werden in den auf beiden Seiten dieser Struktur gelegenen Bereichen 9 bzw. 10 Sperrschicht-Strukturen mit pn-Übergang bzw. mit npn(pnp)-Übergängen erzeugt. Mit deren Sperrwirkung wird Stromfluß außerhalb der Doppelheteroschichtstruktur verhindert. Das Halbleitermaterial dieser Bereiche 9 und 10 wird außerdem so ausgewählt, daß es vergleichsweise zu dem Halbleitermaterial der aktiven Schicht einen niedrigeren Brechungsindex besitzt. Damit erhält die Laserdiode eine dielektrische Wellenführung für die in der laseraktiven Zone 6 erzeugte Laserstrahlung. Es wird dies als Index-Führung bezeichnet.

7.8.1984 / Bts 1 Bla
14.6.1985/Bts 1 Kow

Die Herstellung eines BH-Lasers mit einer oder mehreren
Sperrschichten in den Seitenbereichen 9, 10 erfolgt üblicherweise in zwei Epitaxieprozessen.  Im ersten Prozeß wird
auf dem Substrat 2 ganzflächig die Doppelheteroschichtstruktur 3, 4, 5 erzeugt.  Es wird dann aus dieser Struktur der Laserstreifen, d.h. ein schmaler Steg herausgeätzt, nämlich die Struktur, von der Fig.1 die stirnseitige Ansicht mit den Schichten 3, 4, 5 und der darauf befindlichen Kontaktelektrode 8 zeigt.  Im zweiten Epitaxieprozeß werden die Seitenbereiche 9 und 10, die sich seitlich des Steges der Doppelheterostruktur 3, 4, 5 und oberhalb der seitlichen Anteile des Substrats 2 erstrecken, mit
Halbleitermaterial gefüllt.  Dabei werden mindestens zwei
Halbleiterschichten mit gegensätzlicher Dotierung (n-p oder
p-n) epitaktisch aus dotiertem Material abgeschieden, daß
schließlich dort eine sperrende Schichtfolge npn (oder pnp)
vorliegt.  In diese 3-Schichtfolge ist z.B. auch das Material des Substratkörpers 2 mit eingeschlossen. Ein derartiger BH-Laser bzw. ein derartiges Herstellungsverfahren mit
solchen epitaktischen Abscheidungen, mit denen auch die pn-
Übergänge in den Seitenbereichen 9, 10 erzeugt werden, ist
aus der US-PS 4 426 700 bekannt. Eine dort außerdem beschriebene Diffusion bezieht sich nur auf bekannte Herstellung eines elektrisch leitenden Außenkontaktes.

Aus Appl. Phys. Letters, Bd. 43 (1983), S. 809 - 811, ist
eine Laserdiode einer anderen Struktur, nämlich ein RIDS-
Laser, bekannt. Im Gegensatz zu der für die vorliegende
Erfindung erforderlichen BH-Struktur mit dem bei der BH-
Struktur notwendigen streifenförmigen Steg mit den sich
seitlich anschließenden (oben erörterten) Seitenbereichen 9,
10, hat dieser RIDS-Laser ganzflächig diffusionsdotierte
Schichten. Diese ganzflächige Diffusion in der einen Schicht
beruht auf einem entsprechend ganzflächigen Ausdiffundieren des betreffenden Dotierstoffes aus einer darüberliegenden, bereits als Festkörper vorliegenden Schicht. Abgesehen von der durch diese Diffusion dotierten Schicht bleibt auch die Schicht dieser Diffusionsquelle dauernder Bestandteil der fertigen Laserdiode.

Bei dem RIDS-Laser bzw. bei dessen Herstellungsverfahren kommt es darauf an, in der durch Diffusion zu dotierenden Schicht einen mittleren Streifen, jedoch in Richtung der Dicke gesehen, durch und durch zu dotieren, während dies für die Diffusionsdotierung in den Seitenbereichen nicht erfolgt. Um dies zu erreichen, hat man den ursprünglichen Substratkörper dieser bekannten Diode, und zwar schon vor dem Aufbringen jeglicher Epitaxieschichten mit einem Steg versehen, der lediglich in geometrischen Abmessungen entsprechend einem bei einem BH-Laser vorhandenen Steg entspricht. Die Funktion dieses Steges des RIDS-Lasers dient lediglich dazu, für zumindest die erste auf dem Substratkörper abgeschiedene Schicht über die Abscheidungsfläche hinweg unterschiedliche Schichtdicke dieser ersten Schicht zu erreichen.

Seitlich der laseraktiven Zone RIDS-Lasers elektrischen Stromfluß sperrende Schichten sind dort epitaktisch aus bereits dotiertem Material erzeugt.

Es ist jedoch sehr schwierig zu erreichen, daß das Material des zweiten Epitaxieprozesses einwandfrei an den seitlichen Flächen der Schichtfolge 3, 4, 5, d.h. der Doppelheteroschichtstruktur, anwächst, nämlich so zuverlässig anwächst, daß dort zwischen dieser Doppelheteroschichtstruktur und der jeweiligen sperrenden pn-Übergangsstruktur der Bereiche 9 und 10 keine Leckstrompfade auftreten können.

**0185854**

Aufgabe der Erfindung ist es, ein solches Herstellungsverfahren anzugeben, das zu einer Halbleiter-Laserdiode mit vergrabener Heterostruktur führt, bei der solche Leckstrompfade
verhindert sind und dennoch die Herstellung dieser Diode
nicht erschwert ist.

Diese Aufgabe wird mit den Merkmalen des Patentanspruchs 1
gelöst. Weitere Ausgestaltungen und Weiterbildungen der Erfindung gehen aus den Unteransprüchen hervor.

Erläuterungen zur vorliegenden Erfindung gehen aus der nachfolgenden, anhand der Figuren gegebenen Beschreibung hervor.

Fig.2a zeigen die Prozeßschritt-Folge eines Ausführungsbei-
bis
Fig.2d spiels der Erfindung.

Mit 2 ist ein Substratkörper bezeichnet, auf dem sich eine
Doppelheteroschichtstruktur 3, 4, 5 befindet, wobei die eine
Schicht 3 (wie beim Beispiel der Fig.1) ein Anteil des Substratkörpers 2 ist. Beispielsweise bestehen der Substratkörper 2 und damit die Schicht 3 aus Indiumphosphid, die
Schicht 4 aus Indium-Gallium-Arsenidphosphid und die Schicht
5 wieder aus Indiumphosphid. Bei diesem Beispiel sind das
Material des Substratkörpers 2 und der Schicht 3 n-dotiert
und die beiden Schichten 4 und 5 sind p-dotiert. Wie beim
vorangehend beschriebenen Stand der Technik ist die Schichtenfolge vorzugsweise durch Epitaxie und die Geometrie des
Steges des Streifens durch Ätzen hergestellt. Das Ätzen
wird so durchgeführt, daß dieser Steg exakt bis unterhalb
der Schicht 4, d.h. seitlich bis unterhalb der aktiven Zone
6, freigeätzt ist und daß das dann seitlich freiliegende
Material n-leitend ist. Die Fig.2a zeigt diesen nach dem
Ätzen erreichten Zustand.

Wie in der Herstellung von Halbleiter-Bauelementen üblich,
werden auf bzw. in einer größeren Halbleiter-Substratscheibe
gleichzeitig eine Vielzahl nebeneinander angeordneter Strukturen wie sie Fig.2a zeigt hergestellt. Eine Halbleiter Substratscheibe mit einer Vielzahl solcher für das Einzelbauelement einer Laserdiode gezeigten Strukturen wird nachfolgend
in einer Flüssigphasen-Epitaxieanlage mit einer p-Dotierstoff
(z.B. Zink, Kadmium, Magnesium) enthaltenden Halbleitermaterial-Schmelze 32 in Kontakt gebracht. Diese Schmelze ist erfindungsgemäß so ausgewählt, daß sie sich mit dem Indiumphosphid des Substratkörpers 2 bzw. der eine Vielzahl solcher
Substratkörper enthaltenden Halbleiter-Substratscheibe im
Lösungs-Gleichgewicht befindet. Es wird z.B. eine phosphorgesättigte Indiumschmelze verwendet. Das Gleichgewicht
gewährleistet, daß weder Indiumphosphid des Substratkörpers
2 bzw. der Halbleiterscheibe und/oder der Schichtfolge 3,4,5
aufgelöst wird (was bei Untersättigung der Schmelze eintreten könnte), noch daß aus der Schmelze p-Indiumphosphid epitaktisch aufwächst (was bei Übersättigung der Schmelze eintreten könnte). Vielmehr ist bei diesem in Fig.2b angedeuteten Verfahrensschritt der Erfindung erreicht, daß nur
Dotierstoff in das Halbleitermaterial eindiffundiert und an
der Halbleiterstruktur (nach Fig.2a) lediglich eine jeweils
oberflächennahe Zone 42 aus (bisher n-leitendem) Indiumphosphid nunmehr p-leitend gemacht ist. Diese Zone 42 kann auf
wenige Zehntel µ-Meter bemessen werden. Durch Wahl der
Dauer und Temperatur der Diffusion kann dies eingehalten werden.

Fig.2b zeigt das mit diesem erfindungsgemäß vorgesehenen Verfahrensschritt erreichte Ergebnis, wobei auch auf die Unterdiffusion unter die Schicht 4 hinzuweisen ist. Die Zonen 42
liegen deutlich unterhalb der Schicht 4, die im wesentlichen
die laseraktive Zone 6 enthält.

Mit dieser Maßnahme ist erreicht, daß nunmehr die Schicht 3,
an ihren den Bereichen 9 und 10 zugewandten, seitlich des
Streifens liegenden Oberflächen ausschließlich p-leitend ist,
wobei die Dicke der eindiffundierten Schicht auf wenige Zehntel µm beschränkt bleibt. Dies läßt sich durch Wahl der Diffusionsdauer und der dabei angewandten Temperaturen steuern.

Durch Abschieben des Materials der Schmelze 31 wird der gesamte Diffusionsvorgang beendet, wobei während dieses Diffusionsvorgangs zumindest im wesentlichen weder ein Aufwachsen
noch ein Abtragen von Halbleitermaterial auf die bzw. von der Struktur der Schichtfolge 3,4,5 nach Fig.2a erfolgt ist.

Nachdem diese wichtige Maßnahme dieses Diffusionsvorgangs
nach Fig.2b durchgeführt worden ist, kann anschließend durch
Aufschieben einer weiteren Halbleiter-Schmelze Halbleitermaterial zum epitaktischen Aufwachsen gebracht werden. Wie
z.B. Fig.2c zeigt, läßt man n-dotiertes Indiumphosphid aufwachsen. Dies kann entweder selektiv nur in den Seitenbereichen 9 und 10 oder (wie Fig.2c zeigt) ganzflächig erfolgen. So entsteht ein sperrender pn-Übergang mit örtlich
definierter Lage in der Ebene der (in den Figuren dargestellten) Unterseite der Schicht 4, in der sich die laseraktive Zone befindet. Bei ganzflächigem Aufwachsen entsteht
zunächst oberhalb der obersten Schicht 5 der Doppelhetero-
schichtstruktur n-leitendes Halbleitermaterial, durch das
eine sperrfreie Verbindung vom Kontakt 8 zur Doppelhetero-
schichtstruktur verlorengehen würde. Es wird dementsprechend - wie dies aus Fig.2d hervorgeht - durch eine Streifenmaske hindurch noch eine p-Diffusion durchgeführt, so daß
ein p-leitender Bereich 51 im zuvor aufgebrachten n-Indiumphosphid 41 entsteht.

Die für die Diffusion des Bereiches 51 verwendete Streifenmaske ist vorzugsweise eine Oberflächenbeschichtung aus beispielsweise Siliziumdioxid, die in Fig.2d mit 52 bezeichnet
ist und die auf der Struktur verbleiben kann. Mit 81 ist
die Kontaktelektrode bezeichnet, die z.B. eine flächige Metallbeschichtung ist.

Eine Variation des obigen Verfahrens besteht darin, tatsächlich eine niedrig dotierte Schicht 3 auf dem dagegen hochdotierten Substrat 2 vorzusehen, wie dies gestrichelt in
Fig.2a berücksichtigt ist. Diese Schicht 3 und das Substrat 2 haben dabei Dotierung gleichen Leitungstyps, sie

sind z.B. n-leitend. Den stark unterschiedlichen Dotierungsgraden entsprechend wird in den seitlich des Steges
(4, 5) gelegenen Seitenbereichen 9 und 10 vorzugsweise nur
die Schicht 3 über ihre gesamte Dicke hinweg mittels der
Schmelze 31 umdotiert. Das Substrat 2 jedoch bleibt praktisch unverändert.

Eine weitere Variation ist, zunächst die ganze Schicht 4
(zusammen mit den Anteilen 4a) beim Ätzen stehenzulassen und
diese Anteile 4a mittels der Schmelze 31 aufzulösen, mit der
das Material dieser ohnehin sehr dünnen Schicht 4 nicht im
Lösungsgleichgewicht ist. Diese Variation hat den Vorteil,
daß dieses Auflösen exakt an der Grenze zwischen den Schichten 3 und 4 stoppt, was dem obenerwähnten Ätzen exakt bis
zur Grenzfläche der Schichten 4 und 3 entspricht.

Bei diesen beiden Varianten sind die übrigen Verfahrensschritte unverändert oder gegebenenfalls sinngemäß unverändert auszuführen.

Es sei darauf hingewiesen, daß die wichtige, erfindungsgemäß durchgeführte Maßnahme der Eindiffusion aus der während
des Verfahrens angewendeten und nur zu dieser Eindiffusion
des Dotierungsstoffes in die Zoenen (42) benutzten Schmelze
31 auch an der fertigen Diode nachweisbar ist. Zum einen
sind die Zonen 42, z.B. im GEgensatz zur US-PS 4 426 700,
geometrisch ebenso eben wir dies die Schicht 3 bzw. der der
Schicht 3 entsprechende Anteil des Substrats 2 ist. Auch beruht die schon oben erwähnte vorteilhafte Unterdiffusion
unter die Ränder der Schicht 4 auf dieser Maßnahme. Die
Richtung der Eindiffusion ist aus dem erzeugten Diffusionsprofil nachweisbar.

**0185854**

<u>Patentansprüche:</u>

1. Laserdiode
- die eine vergrabene, streifenförmige Doppelhetero-Schichtstruktur (3,4,5) mit einer ersten (3), einer zweiten
  (4) und einer dritten (5) Schicht und entsprechend streifenförmiger, laseraktiver Zone (6) aufweist,
- bei der in den an die streifenförmige Schichtstruktur
  (3,4,5) angrenzenden Seitenbereichen (9, 10) weitere
  Halbleiterstrukturen (41) mit vergleichsweise zu der
  streifenförmigen Schichtstruktur (3,4,5) niedrigerem
  Brechungsindex vorhanden sind und
- bei der in den Seitenbereichen (9, 10) eine jeweilige,
  an die weiteren Strukturen (41) angrenzende Zone (42)
  vorhanden ist, die eine Dotierung mit einem Leitungstyp
  (p) aufweist, der dem Leitungstyp (n) der Dotierung der
  weiteren Strukturen (41) und der in Nachbarschaft der
  laseraktiven Zone (6) in der ersten Schicht (3) vorliegenden Dotierung entgegengesetzt ist, so daß ein jeweiliger sperrender pn-Übergang seitlich der streifenförmigen Schichtstruktur (3,4,5) in der Grenzfläche
  zwischen der ersten Schicht (3) dieser Schichtstruktur
  (3,4,5) und den anschließenden weiteren Strukturen (41)
  vorliegt,
  g e k e n n z e i c h n e t  dadurch ,
- daß diese Dotierung (p) in der jeweiligen angrenzenden
  Zone (42) ein Dotierstoff, der aus lediglich der Richtung
  der Grenzfläche zwischen der jeweiligen angrenzenden Zone
  (42) und der jeweils benachbarten weiteren Struktur (41)
  kommend eindiffundiert ist, jedoch nicht aus dem Material
  dieser jeweiligen weiteren Struktur (41) ausdiffundiert
  ist.

2. Laserdiode nach Anspruch 1,  g e k e n n -

zeichnet dadurch , daß die erste Schicht (3) der Doppelhetero-Schichtstruktur Anteil eines Substratkörpers (2) dieser Schichtstruktur ist.

3. Verfahren zur Herstellung einer Laserdiode nach Anspruch 1 oder 2,
bei der nach Herstellung der Schichten der Doppelhetero-Schichtstruktur (3,4,5) der Steg (Fig.2a) für die Streifenform der Laserdiode hergestellt worden ist,
g e k e n n z e i c h n e t     dadurch,
–daß wenigstens im Bereich der Seitenbereiche (9, 10) des Steges (Fig. 2a) der Schichtstruktur (3,4,5) die jetzt freiliegenden Oberflächenteile der Schichtstruktur (3,4,5) mit einer derartigen Halbleiterschmelze in Berührung gebracht werden, die mit dem für die jeweilige angrenzende Zone (42) vorgesehenen Dotierstoff versetzt ist und die hinsichtlich des Lösungsgleichgewichtes zwischen dem Halbleitermaterial wenigstens der ersten und der dritten Schicht (3,5) der Schichtstruktur (3,4,5) so eingestellt ist, daß für diese Schichten (3,5) weder wesentliche epitaktische Abscheidung noch Abtragung von Halbleitermaterial eintritt, daß aber die Eindiffusion des Dotierstoffes aus dieser Schmelze (31) in die jeweilige angrenzende Zone (42) erfolgt,
–daß die Schmelze (31) nach Abschluß der Eindiffusion in die jeweilige angrenzende Zone (42) wieder entfernt wird und
–daß danach das Material der weiteren Halbleiterstrukturen (41) abgeschieden wird, wobei für dieses abgeschiedene Halbleitermaterial ein dem Leitungstyp der jeweiligen angrenzenden Zone (42) entgegengesetzter Leitungstyp gewählt ist.

4. Verfahren nach Anspruch 3, bei dem der Steg der streifenförmigen Struktur (3,4,5) durch Abtragung der zweiten und der dritten Schicht (4,5) der Doppelhetero-Schichtstruktur
erzeugt ist,

g e k e n n z e i c h n e t  dadurch ,

daß die Einstellung der Schmelze (31) hinsichtlich des Lösungsgleichgewichtes so gewählt ist, daß keine wesentliche
epitaktische Abscheidung oder Abtragung für sämtliche Schichten (3, 4, 5) der Doppelhetero-Schichtstruktur eintritt.


5. Verfahren nach Anspruch 4, bei dem für den Steg zunächst
nur die dritte Schicht der Doppelhetero-Schichtstruktur
abgetragen worden ist,

g e k e n n z e i c h n e t  dadurch ,

daß die Einstellung hinsichtlich des Lösungsgleichgewichts
so gewählt ist, daß keine wesentliche epitaktisch Abscheidung erfolgt, kein wesentliches Abtragen von Material der
ersten und der dritten Schicht (3, 5) der Doppelhetero-
Schichtstruktur erfolgt, jedoch das Material der zweiten
Schicht (4) der Doppelhetero-Schichtstruktur außerhalb
des Steges der streifenförmigen Struktur (3,4,5) vollständig
abgetragen wird.


6. Verfahren nach Anspruch 3, 4 oder 5, g e k e n n -
z e i c h n e t  dadurch, daß bei Abscheidung von Material
der weiteren Struktur (41) auch auf derjenigen Oberfläche
der Doppelhetero-Schichtstruktur (3, 4, 5), durch die hindurch die Stromzuführung erfolgt, diese Abscheidung im Bereich (51) der vorgesehenen Stromzuführung derart dotiert
wird, daß dieser Bereich (51) gleichen Leitungscharakter wie
die angrenzende Schicht (5) der Doppelhetero-Schichtstruktur
(3, 4, 5) hat.


7. Verfahren nach Anspruch 6, g e k e n n z e i c h n e t
dadurch, daß die Dotierung dieses Bereiches (51) durch eine
Maske (52) hindurch erfolgt, wobei diese Maske (52) auf der

0185854

Anordnung verbleibt.

8. Verfahren nach einem der Ansprüche 4 bis 7, g e -
k e n n z e i c h n e t  dadurch,

- daß das Halbleitermaterial des Substratkörpers (2) n-leitendes Indiumphosphid ist,

- daß für die Doppelhetero-Schichtstruktur (3, 4, 5) aufeinanderfolgend n-leitendes Indiumphosphid, p-leitendes Indiumgalliumarsenidphosphid und darauffolgend p-leitendes Indiumphosphid verwendet worden sind,

- daß für den Diffusionsvorgang der oberflächennahen
Zonen (42) eine Schmelze aus phosphor-gesättigtem Indium
mit p-Dotierstoff als Diffusionsquelle verwendet worden
ist und

- daß für die weitere Schichtstruktur n-leitendes Indiumphosphid abgeschieden worden ist.

**FIG 1**

**FIG 2**

a

b

c

d